# EUROPÄISCHE PATENTANMELDUNG

(11) **EP 3 576 302 A1**
(43) Veröffentlichungstag der Anmeldung: **04.12.2019**
(21) Anmeldenummer: 18174799.9
(22) Anmeldetag: 29.05.2018
(51) Int. Cl.: H03K 17/14

(54) **ANSTEUERN EINES METALL-OXID-HALBLEITER-FELDEFFEKTTRANSISTORS**

(71) Anmelder: Siemens Aktiengesellschaft, 80333 München (DE)
(72) Erfinder: Bakran, Mark-Matthias, 91052 Erlangen (DE); Böhmer, Jürgen, 90547 Stein (DE); Helsper, Martin, 90584 Allersberg (DE); Krafft, Eberhard Ulrich, 90419 Nürnberg (DE); Laska, Bernd, 91074 Herzogenaurach (DE); Nagel, Andreas, 90431 Nürnberg (DE); Schönewolf, Stefan Hans Werner, 90489 Nürnberg (DE); Weigel, Jan, 91077 Großenbuch (DE)

(57) **Zusammenfassung**

Die Erfindung betrifft ein Verfahren und eine Ansteueranordnung (3) zum Ansteuern eines MOSFET (1), insbesondere eines auf einem Halbleiter mit breitem Bandabstand basierenden MOSFET (1). Erfindungsgemäß wird ein Kennlinienblock erstellt, in dem abhängig von wenigstens einer das Schaltverhalten des MOSFET (1) beeinflussenden Betriebskenngröße (U, T) eine einer Änderung des Schaltverhaltens durch die wenigstens eine Betriebskenngröße (U, T) entgegenwirkende Änderung (ΔU1, ΔU2, ΔR1, ΔR2) wenigstens einer Ansteuergröße (U1, U2, R1, R2) zum Ansteuern des MOSFET (1) gegenüber einem Referenzansteuerwert der Ansteuergröße (U1, U2, R1, R2) hinterlegt wird. Im Betrieb des MOSFET (1) wird ein Istwert der wenigstens einen Betriebskenngröße (U, T) ermittelt und die wenigstens eine Ansteuergröße (U1, U2, R1, R2) wird gegenüber ihrem Referenzansteuerwert gemäß dem Kennlinienblock in Abhängigkeit von dem Istwert der wenigstens einen Betriebskenngröße (U, T) geändert.

## Beschreibung

Die Erfindung betrifft ein Verfahren und eine Ansteueranordnung zum Ansteuern eines Metall-Oxid-Halbleiter-Feldeffekttransistors (MOSFET = Metal-Oxide-Semiconductor Field-Effect Transistor), insbesondere eines auf einem Halbleiter mit breitem Bandabstand (Wide-Bandgap Semiconductor) basierenden MOSFET.

Das Schaltverhalten eines MOSFET hängt stark von Betriebsbedingungen ab, unter denen der MOSFET betrieben wird, insbesondere von einer Betriebsspannung, die im ausgeschalteten Zustand des MOSFET zwischen Drain und Source des MOSFET anliegt, und einer Betriebstemperatur des MOSFET. Für Anwendungen eines MOSFET ist ein vorhersagbares und gleichbleibendes Schaltverhalten des MOSFET erforderlich, um Grenzbedingungen, beispielsweise für eine Überspannung beim Abschalten des MOSFET und für die elektromagnetische Verträglichkeit, einzuhalten. Gerade in Anwendungen mit stark schwankenden Betriebsbedingungen werden gegenwärtig vermehrt auf Halbleitern mit breitem Bandabstand basierende MOSFET eingesetzt, beispielsweise in Traktionsstromrichtern, bei denen die Betriebsspannung stark schwanken kann.

Der Erfindung liegt die Aufgabe zugrunde, ein Verfahren und eine Ansteueranordnung zum Ansteuern eines MOSFET anzugeben, die hinsichtlich der Konstanz des Schaltverhaltens des MOSFET unter wechselnden Betriebsbedingungen verbessert sind.

Die Aufgabe wird erfindungsgemäß durch ein Verfahren mit den Merkmalen des Anspruchs 1 und eine Ansteueranordnung mit den Merkmalen des Anspruchs 8 gelöst.

Vorteilhafte Ausgestaltungen der Erfindung sind Gegenstand der Unteransprüche.

Bei dem erfindungsgemäßen Verfahren zum Ansteuern eines MOSFET, insbesondere eines auf einem Halbleiter mit breitem Bandabstand basierenden MOSFET, wird ein Kennlinienblock erstellt, in dem abhängig von wenigstens einer das Schaltverhalten des MOSFET beeinflussenden Betriebskenngröße eine einer Änderung des Schaltverhaltens durch die wenigstens eine Betriebskenngröße entgegenwirkende Änderung wenigstens einer zum Ansteuern des MOSFET verwendeten Ansteuergröße gegenüber einem Referenzansteuerwert der Ansteuergröße hinterlegt wird. Im Betrieb des MOSFET wird ein Istwert der wenigstens einen Betriebskenngröße ermittelt und die wenigstens eine Ansteuergröße wird gegenüber ihrem Referenzansteuerwert gemäß dem Kennlinienblock in Abhängigkeit von dem Istwert der wenigstens einen Betriebskenngröße geändert.

Die Erfindung nutzt aus, dass die Abhängigkeit des Schaltverhaltens eines MOSFET von das Schaltverhalten beeinflussenden Betriebskenngrößen sehr präzise durch Kennlinien abgebildet werden kann, die zur Ansteuerung des MOSFET verwendete Ansteuergrößen in Abhängigkeit von den Betriebskenngrößen beschreiben. Die Erfindung sieht vor, einen Kennlinienblock zu erstellen, der eine oder mehrere Kennlinien aufweist, die jeweils Änderungen einer Ansteuergröße gegenüber einem Referenzansteuerwert in Abhängigkeit von wenigstens einer Betriebskenngröße ausweisen, die erforderlich sind, um Änderungen des Schaltverhaltens durch die wenigstens eine Betriebskenngröße entgegenzuwirken. Die Ansteuergrößen werden gemäß dem Kennlinienblock in Abhängigkeit von Istwerten der wenigstens einen Betriebskenngröße eingestellt. Dadurch kann der Einfluss wenigstens einer Betriebskenngröße auf das Schaltverhalten des MOSFET kompensiert werden, so dass das Schaltverhalten des MOSFET stabilisiert wird.

Ausgestaltungen der Erfindung sehen vor, dass in dem Kennlinienblock die Änderung einer Einschaltansteuerspannung für ein Einschalten des MOSFET, die Änderung einer Ausschaltansteuerspannung für ein Ausschalten des MOSFET, die Änderung eines Einschaltgatewiderstands für ein Einschalten des MOSFET und/oder die Änderung eines Ausschaltgatewiderstands für ein Ausschalten des MOSFET in Abhängigkeit von der wenigstens einen Betriebskenngröße hinterlegt wird. Mit anderen Worten sehen diese Ausgestaltungen der Erfindung eine Einschaltansteuerspannung, eine Ausschaltansteuerspannung, einen Einschaltgatewiderstand und/oder einen Ausschaltgatewiderstand für den MOSFET als jeweils eine Steuergröße vor, deren Änderung in Abhängigkeit von der wenigstens einen Betriebskenngröße in dem Kennlinienblock hinterlegt wird. Diese Ausgestaltungen der Erfindungen ermöglichen vorteilhaft eine direkte Beeinflussung der Gate-Source-Spannung des MOSFET für das Einschalten und/oder Ausschalten des MOSFET in Abhängigkeit von der wenigstens einen Betriebskenngröße.

Weitere Ausgestaltungen der Erfindung sehen vor, dass in dem Kennlinienblock die Änderung der wenigstens einen Ansteuergröße in Abhängigkeit von einer Betriebsspannung und/oder von einer Betriebstemperatur des MOSFET hinterlegt wird. Diese Ausgestaltungen der Erfindung berücksichtigen, dass das Schaltverhalten des MOSFET vor allem von der Betriebsspannung und der Betriebstemperatur abhängt und das Schaltverhalten des MOSFET deshalb vor allem durch die Kompensation der Einflüsse dieser beiden Betriebskenngrößen stabilisiert werden kann.

Eine erfindungsgemäße Ansteueranordnung zur Durchführung des erfindungsgemäßen Verfahrens umfasst eine Auswerteeinheit, die dazu ausgebildet ist, den Kennlinienblock zu speichern und die Änderung der wenigstens einen Ansteuergröße in Abhängigkeit von dem Istwert der wenigstens einen Betriebskenngröße anhand des Kennlinienblocks zu ermitteln, und eine Steuereinheit, die dazu ausgebildet ist, den MOSFET in Abhängigkeit von einem Steuersignal mit einem Ansteuerwert der wenigstens einen Ansteuergröße anzusteuern, der gegenüber dem Referenzansteuerwert der Ansteuergröße gemäß der von der Auswerteeinheit ermittelten Änderung geändert ist.

Ausgestaltungen der erfindungsgemäßen Ansteueranordnung sehen vor, dass die Steuereinheit eine steuerbare Einschaltspannungsquelle zur Erzeugung einer veränderbaren Einschaltansteuerspannung für ein Einschalten des MOSFET, eine steuerbare Ausschaltspannungsquelle zur Erzeugung einer veränderbaren Ausschaltansteuerspannung für ein Ausschalten des MOSFET, eine steuerbare Einschaltwiderstandseinheit zur Erzeugung eines veränderbaren Einschaltgatewiderstands für ein Einschalten des MOSFET und/oder eine steuerbare Ausschaltwiderstandseinheit zur Erzeugung eines veränderbaren Ausschaltgatewiderstands für ein Ausschalten des MOSFET aufweist.

Eine weitere Ausgestaltung der erfindungsgemäßen Ansteueranordnung sieht eine Messvorrichtung zur Erfassung von Istwerten wenigstens einer Betriebskenngröße vor, deren Einfluss auf das Schaltverhalten des MOSFET in dem Kennlinienblock berücksichtigt ist. Beispielsweise ist die Messvorrichtung zur Erfassung von Istwerten einer Betriebsspannung und/oder einer Betriebstemperatur des MOSFET ausgebildet.

Eine erfindungsgemäße Ansteueranordnung ermöglicht die Durchführung des erfindungsgemäßen Verfahrens. Die Vorteile einer erfindungsgemäßen Ansteueranordnung entsprechen daher den oben bereits genannten Vorteilen des erfindungsgemäßen Verfahrens und werden hier nicht noch einmal gesondert aufgeführt.

Ein erfindungsgemäßer Stromrichter, insbesondere ein Traktionsstromrichter, weist wenigstens einen MOSFET, insbesondere einen auf einem Halbleiter mit breitem Bandabstand basierenden MOSFET, und eine erfindungsgemäße Ansteueranordnung zum Ansteuern des MOSFET auf. Die Erfindung eignet sich insbesondere für das Ansteuern eines MOSFET eines Traktionsstromrichters, da die Betriebsspannung eines Traktionsstromrichters stark schwanken und somit das Schaltverhalten des MOSFET verändern kann.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
- FIG 1: einen Schaltplan eines MOSFET und eines ersten Ausführungsbeispiels einer Ansteueranordnung zum Ansteuern des MOSFET,
- FIG 2: einen Schaltplan einer Steuereinheit zum Ansteuern eines MOSFET,
- FIG 3: eine Kennlinie für eine Änderung einer Einschaltansteuerspannung in Abhängigkeit von einer Betriebsspannung eines MOSFET,
- FIG 4: einen Schaltplan eines Stromrichters,
- FIG 5: ein Ablaufdiagramm eines Verfahrens zum Ansteuern eines MOSFET.

Einander entsprechende Teile sind in den Figuren mit denselben Bezugszeichen versehen.

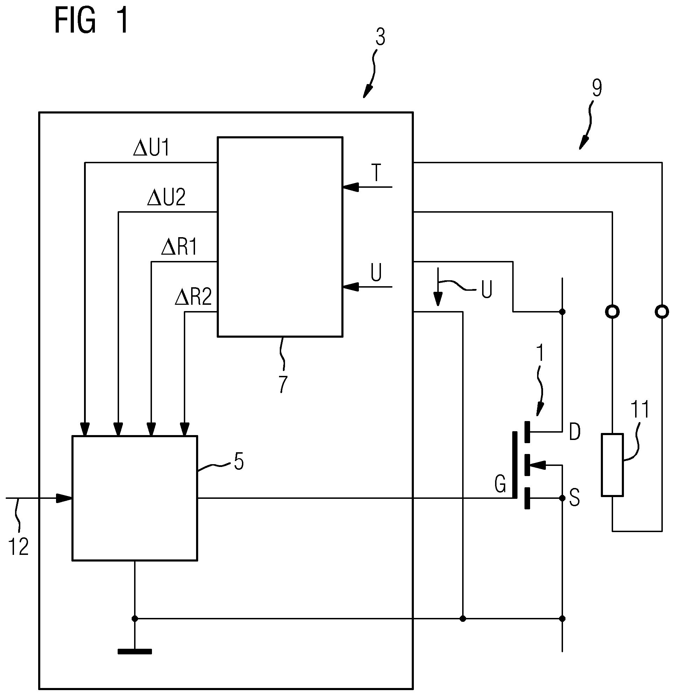

FIG 1 zeigt einen Schaltplan eines MOSFET 1 und eines ersten Ausführungsbeispiels einer erfindungsgemäßen Ansteueranordnung 3 zum Ansteuern des MOSFET 1.

Der MOSFET 1 ist als ein normal sperrender n-Kanal-MOSFET ausgebildet, der auf einem Halbleiter mit breitem Bandabstand, beispielsweise auf Siliciumcarbid oder Galliumnitrid, basiert.

Die Ansteueranordnung 3 umfasst eine Steuereinheit 5, eine Auswerteeinheit 7 und eine Messvorrichtung 9.

Die Messvorrichtung 9 ist dazu ausgebildet, als Betriebsgrößen T, U eine Betriebstemperatur T und eine Betriebsspannung U des MOSFET 1 zu erfassen. Zum Erfassen der Betriebstemperatur T weist die Messvorrichtung 9 einen Temperatursensor 11, beispielsweise einen NTC-Widerstand (Negative Temperature Coefficient Thermistor), auf. Die Betriebsspannung U wird beispielsweise als eine Drain-Source-Spannung des MOSFET 1 zwischen Drain D und Source S im ausgeschalteten Zustand des MOSFET 1 gemessen.

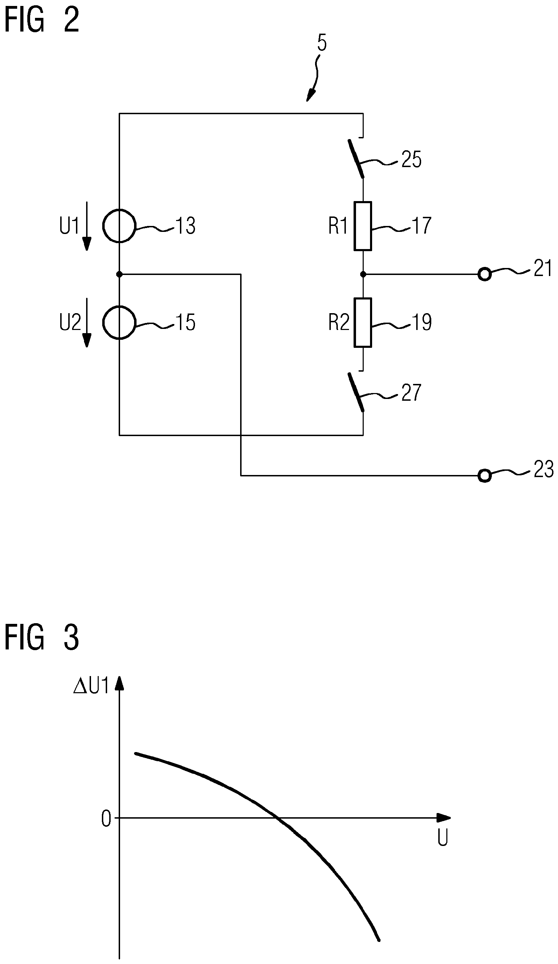

FIG 2 zeigt schematisch einen Schaltplan der Steuereinheit 5. Die Steuereinheit 5 umfasst eine steuerbare Einschaltspannungsquelle 13 zur Erzeugung einer veränderbaren Einschaltansteuerspannung U1 für ein Einschalten des MOSFET 1, eine steuerbare Ausschaltspannungsquelle 15 zur Erzeugung einer veränderbaren Ausschaltansteuerspannung U2 für ein Ausschalten des MOSFET 1, eine steuerbare Einschaltwiderstandseinheit 17 zur Erzeugung eines veränderbaren Einschaltgatewiderstands R1 für das Einschalten des MOSFET 1, eine steuerbare Ausschaltwiderstandseinheit 19 zur Erzeugung eines veränderbaren Ausschaltgatewiderstands R2 für das Ausschalten des MOSFET 1, einen mit dem Gate G des MOSFET 1 verbundenen ersten Anschluss 21 und einen mit dem Source S des MOSFET 1 verbundenen zweiten Anschluss 23. Die Einschaltwiderstandseinheit 17 und die Ausschaltwiderstandseinheit 19 weisen beispielsweise jeweils eine Vielzahl von Einzelwiderständen auf, wobei zur Einstellung eines bestimmten Einschaltgatewiderstands R1 beziehungsweise Ausschaltgatewiderstands R2 jeweils eine dazu erforderliche Anzahl der Einzelwiderstände miteinander verschaltbar sind.

Jeweils ein erster Pol der Einschaltspannungsquelle 13 und ein erster Pol der Ausschaltspannungsquelle 15 sind permanent mit dem zweiten Anschluss 23 verbunden. Zum Einschalten des MOSFET 1 wird der zweite Pol der Einschaltspannungsquelle 13 durch Schließen eines ersten Schalters 25 über die Einschaltwiderstandseinheit 17 mit dem ersten Anschluss 21 verbunden und der zweite Pol der Ausschaltspannungsquelle 15 wird durch Öffnen eines zweiten Schalters 27 von der Ausschaltwiderstandseinheit 19 und dem ersten Anschluss 21 getrennt. Zum Ausschalten des MOSFET 1 wird der zweite Pol der Ausschaltspannungsquelle 15 durch Schließen des zweiten Schalters 27 über die Ausschaltwiderstandseinheit 19 mit dem ersten Anschluss 21 verbunden und die Einschaltspannungsquelle 13 wird durch Öffnen des ersten Schalters 25 von der Einschaltwiderstandseinheit 17 und dem ersten Anschluss 21 getrennt. Das Ein- und Ausschalten des MOSFET 1 wird durch ein der Steuereinheit 5 zugeführtes binäres Steuersignal 12 ausgelöst.

Die zum Einschalten des MOSFET 1 verwendete Einschaltansteuerspannung U1 und der zum Einschalten des MOSFET 1 verwendete Einschaltgatewiderstand R1 sowie die zum Ausschalten des MOSFET 1 verwendete Ausschaltansteuerspannung U2 und der zum Ausschalten des MOSFET 1 verwendete Ausschaltgatewiderstand R2 sind Ansteuergrößen U1, U2, R1, R2 zum Ansteuern des MOSFET 1, die jeweils in Abhängigkeit von der Betriebstemperatur T und der Betriebsspannung U des MOSFET 1 eingestellt werden. Dazu ist in der Auswerteeinheit 7 ein Kennlinienblock gespeichert, in dem Änderungen ΔU1, ΔU2, ΔR1, ΔR2 dieser Ansteuergrößen U1, U2, R1, R2 jeweils gegenüber einem Referenzansteuerwert in Abhängigkeit von der Betriebstemperatur T und der Betriebsspannung U hinterlegt sind, die einer durch die Betriebstemperatur T oder Betriebsspannung U verursachten Änderung des Schaltverhaltens des MOSFET 1 entgegenwirken.

Die Auswerteeinheit 7 ermittelt für die Betriebstemperatur T und die Betriebsspannung U, die von der Messvorrichtung 9 erfasst werden, anhand des Kennlinienblocks Änderungen ΔU1, ΔU2, ΔR1, ΔR2 der Ansteuergrößen U1, U2, R1, R2 gegenüber deren jeweiligen Referenzansteuerwerten und übermittelt die Änderungen ΔU1, ΔU2, ΔR1, ΔR2 der Steuereinheit 5. Die Steuereinheit 5 stellt die Einschaltansteuerspannung U1, die Ausschaltansteuerspannung U2, den Einschaltgatewiderstand R1 und den Ausschaltgatewiderstand R2 auf den jeweiligen gegenüber dem Referenzansteuerwert geänderten Ansteuerwert ein.

FIG 3 zeigt beispielhaft eine Kennlinie des Kennlinienblocks für eine Änderung ΔU1 der Einschaltansteuerspannung U1 in Abhängigkeit von der Betriebsspannung U gegenüber dem Referenzansteuerwert für die Einschaltansteuerspannung U1. Der sich aus der Kennlinie für eine Betriebsspannung U ergebende Wert ΔU1 wird zu dem Referenzansteuerwert für die Einschaltansteuerspannung U1 addiert.

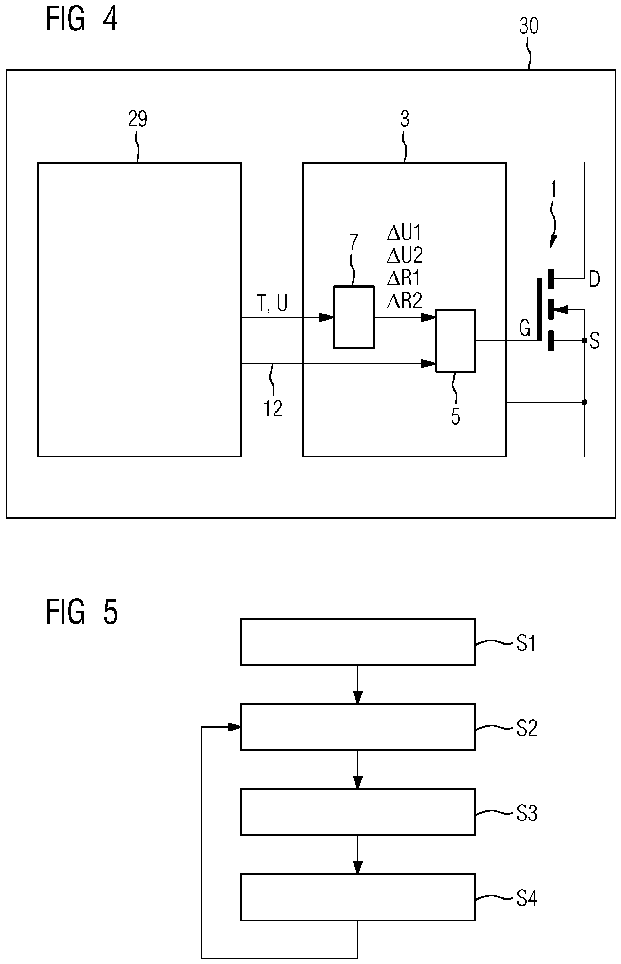

FIG 4 zeigt einen Schaltplan eines Stromrichters 30 mit einem MOSFET 1 und einem zweiten Ausführungsbeispiel einer erfindungsgemäßen Ansteueranordnung 3 zum Ansteuern des MOSFET 1. Der Stromrichter 30 ist beispielsweise ein Traktionsstromrichter mit weiteren (hier nicht dargestellten) MOSFET 1, die in bekannter Weise zu Halb- oder Vollbrücken verschaltet sind, und einer weiteren Ansteueranordnung 3 für jeden weiteren MOSFET 1. Die Ansteueranordnungen 3 dieses Ausführungsbeispiels unterscheiden sich von dem in FIG 1 gezeigten Ausführungsbeispiel lediglich dadurch, dass sie keine Messvorrichtung 9 zum Erfassen der Betriebstemperatur T und der Betriebsspannung U des MOSFET 1 aufweisen. Stattdessen werden der Auswerteeinheit 7 jeder Ansteueranordnung 3 Istwerte der Betriebstemperatur T und der Betriebsspannung U von einer Steuerung 29 des Stromrichters 30 zugeführt, die auch das Steuersignal 12 an die Steuereinheit 5 der Ansteueranordnung 3 sendet.

FIG 5 zeigt ein Ablaufdiagramm eines Ausführungsbeispiels des erfindungsgemäßen Verfahrens zum Ansteuern eines MOSFET 1 mit einer gemäß FIG 1 oder FIG 4 ausgeführten Ansteueranordnung 3.

In einem ersten Verfahrensschritt S1 wird ein Kennlinienblock erstellt, in dem eine Änderung ΔU1 der Einschaltansteuerspannung U1, eine Änderung ΔU2 der Ausschaltansteuerspannung U2, eine Änderung ΔR1 des Einschaltgatewiderstands R1 und eine Änderung ΔR2 des Ausschaltgatewiderstands R2 jeweils in Abhängigkeit von der Betriebstemperatur T und der Betriebsspannung U des MOSFET 1 hinterlegt wird. Der Kennlinienblock wird in der Auswerteeinheit 7 der Ansteueranordnung 3 gespeichert.

In einem zweiten Verfahrensschritt S2 werden die momentane Betriebstemperatur T und die momentane Betriebsspannung U des MOSFET 1 (das heißt Istwerte der Betriebstemperatur T und der Betriebsspannung U) ermittelt und der Auswerteeinheit 7 zugeführt.

In einem dritten Verfahrensschritt S3 werden von der Auswerteeinheit 7 für die in dem zweiten Verfahrensschritt S2 ermittelten Werte der Betriebstemperatur T und der Betriebsspannung U anhand des Kennlinienblocks Änderungen ΔU1, ΔU2, ΔR1, ΔR2 der Einschaltansteuerspannung U1, der Ausschaltansteuerspannung U2, des Einschaltgatewiderstands R1 und des Ausschaltgatewiderstands R2 gegenüber deren jeweiligen Referenzansteuerwerten ermittelt und der Steuereinheit 5 übermittelt.

In einem vierten Verfahrensschritt S4 werden von der Steuereinheit 5 die Einschaltansteuerspannung U1, die Ausschaltansteuerspannung U2, der Einschaltgatewiderstand R1 und der Ausschaltgatewiderstand R2 jeweils auf einen Ansteuerwert eingestellt, der gegenüber dem jeweiligen Referenzansteuerwert durch Addition der in dem dritten Verfahrensschritt S3 ermittelten Änderung ΔU1, ΔU2, ΔR1, ΔR2 zu dem Referenzansteuerwert geändert ist. Nach dem vierten Verfahrensschritt S4 wird das Verfahren mit dem zweiten Verfahrensschritt S2 fortgesetzt.

Die oben anhand der Figuren beschriebenen Ausführungsbeispiele einer erfindungsgemäßen Ansteueranordnung 3 und des erfindungsgemäßen Verfahrens können auf verschiedene Weisen zu alternativen Ausführungsbeispielen abgewandelt werden. Beispielsweise können Änderungen ΔU1, ΔU2, ΔR1, ΔR2 der Einschaltansteuerspannung U1, der Ausschaltansteuerspannung U2, des Einschaltgatewiderstands R1 und des Ausschaltgatewiderstands R2 gegenüber jeweiligen Referenzansteuerwerten in Abhängigkeit von entweder nur der Betriebstemperatur T oder nur der Betriebsspannung U statt in Abhängigkeit von sowohl der Betriebstemperatur T als auch der Betriebsspannung U ermittelt und eingestellt werden. Ferner kann vorgesehen sein, Änderungen ΔU1, ΔU2, ΔR1, ΔR2 nur einer Untermenge der Ansteuergrößen U2, U2, R1, R2 gegenüber jeweiligen Referenzansteuerwerten in Abhängigkeit von der Betriebstemperatur T und/oder der Betriebsspannung U zu ermitteln und einzustellen, beispielsweise nur Änderungen ΔU1, ΔU2 der Einschaltansteuerspannung U1 und der Ausschaltansteuerspannung U2 oder nur Änderungen ΔR1, ΔR2 des Einschaltgatewiderstands R1 und des Ausschaltgatewiderstands R2. Ferner kann im Falle einer Berücksichtigung der Betriebstemperatur T vorgesehen sein, die momentane Betriebstemperatur T des MOSFET 1 anhand eines temperaturabhängigen elektrischen Parameters des MOSFET 1 zu ermitteln, beispielsweise wie in M. Denk and M. M. Bakran, "IGBT Gate Driver with Accurate Measurement of Junction Temperature and Inverter Output Current," PCIM Europe 2017; International Exhibition and Conference for Power Electronics, Intelligent Motion, Renewable Energy and Energy Management, Nürnberg, Deutschland, 2017, S. 1-8, oder die momentane Betriebstemperatur T mit Hilfe eines Modells zu bestimmen, das die Betriebstemperatur T unter Verwendung anderer Betriebsbedingungen schätzt.

Zu FIG 4 alternative Ausführungsbeispiele eines Stromrichters 19 ergeben sich durch Ersetzen der in FIG 4 gezeigten Ansteueranordnung 3 durch eine Ansteueranordnung 3 des in Figur 1 beschriebenen Ausführungsbeispiels oder eines der vorgenannten modifizierten Ausführungsbeispiele.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Verfahren zum Ansteuern eines MOSFET (1), insbesondere eines auf einem Halbleiter mit breitem Bandabstand basierenden MOSFET (1), wobei
- ein Kennlinienblock erstellt wird, in dem abhängig von wenigstens einer das Schaltverhalten des MOSFET (1) beeinflussenden Betriebskenngröße (U, T) eine einer Änderung des Schaltverhaltens durch die wenigstens eine Betriebskenngröße (U, T) entgegenwirkende Änderung (ΔU1, ΔU2, ΔR1, ΔR2) wenigstens einer Ansteuergröße (U1, U2, R1, R2) zum Ansteuern des MOSFET (1) gegenüber einem Referenzansteuerwert der Ansteuergröße (U1, U2, R1, R2) hinterlegt wird,
- im Betrieb des MOSFET (1) ein Istwert der wenigstens einen Betriebskenngröße (U, T) ermittelt wird und
- die wenigstens eine Ansteuergröße (U1, U2, R1, R2) gegenüber ihrem Referenzansteuerwert gemäß dem Kennlinienblock in Abhängigkeit von dem Istwert der wenigstens einen Betriebskenngröße (U, T) geändert wird.

2. Verfahren nach Anspruch 1, wobei in dem Kennlinienblock die Änderung (ΔU1) einer Einschaltansteuerspannung (U1) für ein Einschalten des MOSFET (1) in Abhängigkeit von der wenigstens einen Betriebskenngröße (U, T) hinterlegt wird.

3. Verfahren nach einem der vorhergehenden Ansprüche, wobei in dem Kennlinienblock die Änderung (ΔU2) einer Ausschaltansteuerspannung (U2) für ein Ausschalten des MOSFET (1) in Abhängigkeit von der wenigstens einen Betriebskenngröße (U, T) hinterlegt wird.

4. Verfahren nach einem der vorhergehenden Ansprüche, wobei in dem Kennlinienblock die Änderung (ΔR1) eines Einschaltgatewiderstands (R1) für ein Einschalten des MOSFET (1) in Abhängigkeit von der wenigstens einen Betriebskenngröße (U, T) hinterlegt wird.

5. Verfahren nach einem der vorhergehenden Ansprüche, wobei in dem Kennlinienblock die Änderung (ΔR2) eines Ausschaltgatewiderstands (R2) für ein Ausschalten des MOSFET (1) in Abhängigkeit von der wenigstens einen Betriebskenngröße (U, T) hinterlegt wird.

6. Verfahren nach einem der vorhergehenden Ansprüche, wobei in dem Kennlinienblock die Änderung (ΔU1, ΔU2, ΔR1, ΔR2) der wenigstens einen Ansteuergröße (U1, U2, R1, R2) in Abhängigkeit von einer Betriebsspannung (U) des MOSFET (1) hinterlegt wird.

7. Verfahren nach einem der vorhergehenden Ansprüche, wobei in dem Kennlinienblock die Änderung (ΔU1, ΔU2, ΔR1, ΔR2) der wenigstens einen Ansteuergröße (U1, U2, R1, R2) in Abhängigkeit von einer Betriebstemperatur (T) des MOSFET (1) hinterlegt wird.

8. Ansteueranordnung (3) zur Durchführung des Verfahrens nach einem der vorhergehenden Ansprüche, die Ansteueranordnung (3) umfassend
- eine Auswerteeinheit (7), die dazu ausgebildet ist, den Kennlinienblock zu speichern und die Änderung (ΔU1, ΔU2, ΔR1, ΔR2) der wenigstens einen Ansteuergröße (U1, U2, R1, R2) in Abhängigkeit von dem Istwert der wenigstens einen Betriebskenngröße (U, T) anhand des Kennlinienblocks zu ermitteln, und
- eine Steuereinheit (5), die dazu ausgebildet ist, den MOSFET (1) in Abhängigkeit von einem Steuersignal (12) mit einem Ansteuerwert der wenigstens einen Ansteuergröße (U1, U2, R1, R2) anzusteuern, der gegenüber dem Referenzansteuerwert der Ansteuergröße (U1, U2, R1, R2) gemäß der von der Auswerteeinheit (7) ermittelten Änderung (ΔU1, ΔU2, ΔR1, ΔR2) geändert ist.

9. Ansteueranordnung (3) nach Anspruch 8, wobei die Steuereinheit (5) eine steuerbare Einschaltspannungsquelle (13) zur Erzeugung einer veränderbaren Einschaltansteuerspannung (U1) für ein Einschalten des MOSFET (1) aufweist.

10. Ansteueranordnung (3) nach Anspruch 8 oder 9, wobei die Steuereinheit (5) eine steuerbare Ausschaltspannungsquelle (15) zur Erzeugung einer veränderbaren Ausschaltansteuerspannung (U2) für ein Ausschalten des MOSFET (1) aufweist.

11. Ansteueranordnung (3) nach einem der Ansprüche 8 bis 10, wobei die Steuereinheit (5) eine steuerbare Einschaltwiderstandseinheit (R1) zur Erzeugung eines veränderbaren Einschaltgatewiderstands (R1) für ein Einschalten des MOSFET (1) aufweist.

12. Ansteueranordnung (3) nach einem der Ansprüche 8 bis 11, wobei die Steuereinheit (5) eine steuerbare Ausschaltwiderstandseinheit (R2) zur Erzeugung eines veränderbaren Ausschaltgatewiderstands (R2) für ein Ausschalten des MOSFET (1) aufweist.

13. Ansteueranordnung (3) nach einem der Ansprüche 8 bis 12 mit einer Messvorrichtung (9) zur Erfassung von Istwerten wenigstens einer Betriebskenngröße (U, T), deren Einfluss auf das Schaltverhalten des MOSFET (1) in dem Kennlinienblock berücksichtigt ist.

14. Ansteueranordnung (3) nach Anspruch 13, wobei die Messvorrichtung (9) zur Erfassung von Istwerten einer Betriebsspannung (U) und/oder einer Betriebstemperatur (T) des MOSFET (1) ausgebildet ist.

15. Stromrichter (30), insbesondere Traktionsstromrichter, mit wenigstens einem MOSFET (1) und einer gemäß einem der Ansprüche 8 bis 14 ausgebildeten Ansteueranordnung (3) zum Ansteuern des MOSFET (1).
